# EUROPÄISCHE PATENTSCHRIFT

(11) **EP 3 632 194 B1**
(45) Veröffentlichungstag und Bekanntmachung des Hinweises auf die Patenterteilung: **13.03.2024**
(21) Anmeldenummer: 18713624.7
(22) Anmeldetag: 22.03.2018
(51) Int. Cl.: H05K 5/02, H02K 5/136, H02B 1/28, H02B 13/025, H01H 9/04

(54) **EXPLOSIONSSICHERES GEHÄUSE MIT INNERER DRUCKREDUZIERUNG**
EXPLOSION-PROOF HOUSING HAVING INTERNAL PRESSURE REDUCTION
BOÎTIER ANTIDÉFLAGRANT AVEC RÉDUCTION DE PRESSION INTERNE

(30) Priorität: 01.06.2017 DE 102017112150
(43) Veröffentlichungstag der Anmeldung: 08.04.2020
(73) Patentinhaber: R. Stahl Schaltgeräte GmbH, 74638 Waldenburg (DE)
(72) Erfinder: HERMANOWSKI, Clife, 74743 Seckach (DE); ARNHOLD, Thorsten, 74629 Pfedelbach (DE); LIMBACHER, Bernd, 74523 Schw bisch Hall (DE)
(74) Vertreter: Rüger Abel Patentanwälte PartGmbB
(86) Internationale Anmeldenummer: PCT/EP2018/057338
(87) Internationale Veröffentlichungsnummer: WO 2018/219517

(56) Entgegenhaltungen:
- DD-A3- 261 063
- DE-A1-102009 025 296
- DE-A1-102013 109 259
- DE-B3-102014 206 433
- DE-U1-202008 000 808
- DE-U1-202015 005 015

## Beschreibung

Gegenstand der Erfindung ist ein explosionsgeschütztes Gehäuse, insbesondere ein ein- oder mehrkammeriges Gehäuse der Schutzart Ex-d.

In explosionsgefährdeten Bereichen werden häufig Gehäuse der Schutzart Ex-d eingesetzt. Solche Gehäuse sind so widerstandsfähig ausgebildet, dass sie einer in ihrem Innenraum stattfindenden Zündung eines explosiven Gasgemisches und der infolge der eintretenden Explosion darauf folgenden Druckerhöhung standhalten. Außerdem sind die Gehäuse so gestaltet, dass aus Ihnen keine Flammen oder glühende, als Zündquellen wirkende Partikel nach außen gelangen können. Sollten Spalte vorhanden sein, müssen diese eine Mindestlänge aufweisen und dürfen eine Höchstweite nicht überschreiten. Vorhandene Gehäuseöffnungen sind mit Druckentlastungskörpern versehen, die auch als Flammenschutzfilter bezeichnet werden und verhindern, dass eine im Gehäuse gezündete Flamme nach außen dringt und in der Umgebung vorhandenes explosionsfähiges Gemisch zündet wobei sie andererseits einen Druckausgleich mit der Umgebung bewirken.

Die DD 261 063 A3 beschreibt ein explosionsgeschütztes Gehäuse mit einem in seinem Innenraum angeordneten porösen Körper, beispielsweise aus Schlackenwolle, Glaswolle, Metall oder Keramik mit offenen durchgehenden Poren oder Spalten. Ein solcher in dem Gehäuse angeordneter Körper soll zu einer Senkung des Explosionsdrucks um ca. 90% führen.

Die DE 198 60 286 B4 offenbart ein für einen Bildschirm vorgesehenes Gehäuse, dessen Innenraum teilweise mit einem porösen Dämpfungsmaterial zur Senkung des Explosionsdrucks gefüllt ist. Das Material weist eine Vielzahl im Querschnitt kleiner, nicht geschlossener, sondern durchgehender Kanäle in Form von Poren oder Spalten auf. Der Explosionsdruck soll dadurch auf lediglich etwa 10 Prozent des Explosionsdrucks gemindert werden, das sonst in dem leeren Gehäuse auftreten würde.

Weiter schlägt die DE 10 2014 206433 B3 die Anordnung eines Tablett-Computers in einem mit einer Glasscheibe versehenen explosionssicheren Gehäuse vor, wobei in dem Tablett-Computer ein Dämpfungselement aus offenporiger Steinwolle, Quarzwolle, Glaswolle, Metallschaum oder dergleichen angeordnet ist.

Bei den bekannten Gehäusen mit Körpern aus offenporigem Material handelt es sich teilweise um Speziallösungen, die relativ raumgreifend sind und/oder sehr an die speziellen Gegebenheiten, wie beispielsweise Tablett-Computer, angepasst sind.

Die DE 10 2013 109 259 A1 beschreibt dagegen ein explosionsgeschütztes Gehäuse der Schutzart druckfeste Kapselung (Ex-d), in dessen Gehäusewand ein poröser Druckentlastungskörper vorgesehen ist, durch den ein im Gehäuse aufgebauter Explosionsdruck nach außen dringen kann. Dieses Prinzip nutzen auch die Gehäuse gemäß der US 4,180,177 sowie nach der DE 10 2010 016 782 B4.

Weiter ist aus der DE 2009 025 296 A1 ein Gehäuse bekannt, mit dem elektrische Geräte in explosionsgefährdeten Umgebungen sicher betrieben werden sollen. Das Gehäuse soll sicherstellen, dass im Falle einer Explosion innerhalb des Gehäuses keine Gefährdungen wie zum Beispiel Funken an die explosionsgefährdete Umgebung übergehen. Zur Verringerung des Gewichts und der Wandstärke des Gehäuses unter gleichzeitigen Erfüllung der Explosionsschutzanforderungen wird vorgeschlagen das Gehäuse innen ganz oder teilweise mit energieabsorbierendem Material auszukleiden. Als geeignete Materialien werden metallische Wabenstrukturen, poröse organische Füllstoffe, wie beispielsweise Maisspindeln oder organische Fasern, wie zum Beispiel mit epoxidharzverklebe Flachsfasern angegeben. Mit diesem Material werden eventuelle Öffnungen und Flammenwege überdeckt, womit eine Doppelfunktion erfüllt werden soll, nämlich die Kühlung des ausströmenden heißen Gases und die Dämpfung der Druck und Stoßwelle.

Die Anordnung von druckwellenabsorbierendem Material in einem ansonsten geschlossenen Gehäuse ist auch aus der DE 20 2015 005 015 U1 bekannt. Das dort vorgestellte Gehäuse ist nach außen hin geschlossen. Innen weist es ein oder zwei stoßwellenabsorbierende Elemente auf, die beispielsweise an zueinander im Winkel stehenden Wänden oder frei dem Raum durchquerend angeordnet sind.

Derartige Druckentlastungskörper unterliegen bei Anordnung solcher Gehäuse in widriger Umgebung der Verschmutzung oder bei Wetterbeaufschlagung der Verkeimung, Vereisung und/oder Korrosion. Die Berücksichtigung solcher Umstände führt zu einer Erhöhung des Aufwands.

Es ist Aufgabe der Erfindung, ein Konzept für ein explosionsgeschütztes Gehäuse anzugeben, das vielseitig anwendbar und wenig aufwendig ist.

Diese Aufgabe wird mit dem Gehäuse nach Anspruch 1 gelöst. Weitere bevorzugte Ausführungsformen sind in den abhängigen Ansprüchen definiert.

Das erfindungsgemäße Gehäuse umfasst eine Wandanordnung mit mehreren Wänden, die einen Innenraum umschließen. An wenigstens zwei der Wände der Wandanordnung ist ein offenporiges Material angeordnet. Durch die Anordnung des offenporigen Materials an zwei verschiedenen zum Beispiel einander gegenüberliegenden oder im Winkel zueinander stehenden Wänden wird eine in dem Gehäuse ausgelöste Druckwelle besonders effizient vernichtet. Dies gilt sowohl, wenn jede der mit offenporigen Material versehenen Wände vollflächig mit diesem Material versehen ist, wie auch wenn sich bei einer oder mehreren der mit dem Material versehenen Wände das Material lediglich über einen Teilbereich der betroffenen Wand erstreckt.

Die Nutzung wenigstens zweier oder mehrerer Wandflächen zur Anbringung von offenporigem Material, das eine darauf auftreffende oder daran entlanglaufende Druckwelle dämpft, führt zu einer großen aktiven Dämpfungsfläche und somit zu einer hohen Dämpfungswirkung, auch wenn lediglich relativ dünne Lagen aus offenporigem Material verwendet werden. Damit wird der für die Aufnahme von Komponenten zur Verfügung stehende Teil des Innenraums des Gehäuses durch das offenporige Material nur wenig reduziert. In dem Gehäuse können die Wände teilweise oder komplett mit porösem Material ausgekleidet sein. Die porösen Materialien wirken einerseits als ein nicht zündfähiges Entlastungsvolumen und andererseits als Löschvolumen für eine eindringende Flammenfront. Eine kugelförmige Explosionsfront wird durch die Auskleidung sofort schnellstmöglich großflächig aufgenommen, wobei eine Kühlung und Aufnahme unverbrannter Gase bewirkt wird. Damit wird zum einen die Menge des an der Verbrennung bzw. Explosion teilnehmenden Gases reduziert und andererseits durch Gaskühlung der Druck gemindert. Durch vollständige Auskleidung des Gehäuses innen mit dem offenporigen Material wird ein optimaler Flächen-/Volumen-Faktor für das Gehäuse erhalten.

Durch die Anordnung des offenporigen Materials, vorzugsweise ausschließlich an den Wänden, wird ein großer zusammenhängender Einbauraum für Betriebsmittel, Schalter und dergleichen erhalten.

Vorzugsweise ist das offenporige Material unmittelbar an den wenigstens zwei Wänden anliegend angeordnet. Die dadurch gegebene Wärmeübertragung zwischen dem offenporigen Material und der Gehäusewand kühlt das offenporige Material, so dass dieses einen hohen druckreduzierenden Effekt aufweist. Die Gehäusewand bildet ein an das offenporige Material thermisch angeschlossenen Wärmespeicher.

Das offenporige Material kann vollflächig, stoffschlüssig oder lediglich stellenweise stoffschlüssig mit den Wänden des druckfesten Gehäuses verbunden sein. Dazu kann das poröse Material mit den Wänden verschweißt oder, wenn das Gehäuse im Gussverfahren hergestellt wird, durch Einbringen in die Gussform durch Urformen mit den Gehäusewänden verbunden sein. Andere mechanische form- und/oder stoffschlüssige Verbindungsmöglichkeiten können genutzt werden. Beispielsweise kann das offenporige Material von einer Gitterstruktur eingefasst sein, die mit der Wandanordnung verbunden ist. Die Gitterstruktur kann ein Drahtgitter, ein Lochblech, ein Kunststoffgitter oder dergleichen sein.

Das poröse Material ist vorzugsweise als Platte oder Matte im Wesentlichen gleichbleibender Dicke ausgebildet, so dass die wandabgewandte Fläche parallel oder im spitzen Winkel zu dieser verlaufen angeordnet ist. Damit stehen sich im Innenraum wenigstens zwei Flächen des offenporigen Materials im Wesentlichen gegenüber oder im Winkel zueinander. Beides führt zu einer wirksamen Dämpfung einer dynamisch durchlaufenden Flammenfront.

An von offenporigem Material bedeckten Stellen der Wand ist wenigstens ein Druckentlastungskörper angeordnet. Während das offenporige Material selbst keine Sicherheit gegen Flammendurchschlag bietet, wird die Flammendurchschlagsicherheit nach außen durch den oder die Druckentlastungskörper erbracht. Das offenporige Material kann durch einen oder mehrere Körper aus Metallschaum, aus gesinterten Metallpartikeln, Metallfasern, insbesondere Edelstahlwolle, andere Metallfasern, mineralische Fasern wie Glasfasern, Steinwollfasern, Quarzfasern und ähnlichem gebildet sein. Bei den Körpern aus Fasermaterial kann es sich um nadelgefilzte Anordnungen, d.h. ein Wirrfasergelege mit verfilzten, stofflich jedoch nicht aneinander gebundenen Fasern handeln. Bedarfsweise kann auch eine stoffliche Bindung der Fasern untereinander, z.B. durch ein Bindemittel oder durch Sintern vorhanden sein. Die Fasern führen zu einer Kühlung der aufgenommenen Druckwelle durch Wärmeaufnahme und zu einer Vernichtung der kinetischen Energie der Druckwelle durch innere Reibung der Fasern aneinander. Bevorzugt wird ein Material mit hoher Wärmespeicherkapazität, wie Steinwolle oder Keramikwolle.

Das Fasermaterial des offenporigen Materials kann zu einem Körper in Gestalt von Platten, Quadern oder anderen Formen vorgepresst sein, die in das Gehäuse eingelegt, eingeklebt oder eingeschraubt werden können oder die durch ein Gestell gehalten sind. Die Verdichtung des Faserkörpers ist jedoch vorzugsweise so schwach, dass Abstände und Spalte der porösen Materialen wenigstens an einigen Stellen oberhalb der Grenzspaltenweite des klassischen Explosionsschutzes liegen, d.h. Kühlungseffekt, Strömungseffekt oder sonstige kinetische Effekte, die eine Zündung von in dem Material vorhandenem Gas oder ein Durchlaufen der Flammenfront durch das Material verhindern könnten, sind nicht oder nicht durchgängig vorhanden. Insbesondere wenn das offenporige Material eine hohe Wärmekapazität aufweist, wie es beispielsweise bei Glasfasern, Quarzfasern, Keramikfasern, Steinfasern der Fall ist, wird dennoch eine hohe Druckreduktion erreicht.

Das offenporige Material kann auch durch anorganische oder organische Bindemittel soweit gebunden sein, dass ein offenporiger formstabiler Körper entsteht. Dieser muss nicht zwangsläufig an die Wand anschließen. Ein solcher vorgeformter gebundener Faserkörper, kann auch in dem Gehäuse von vier, fünf oder sechs Seiten zugänglich angeordnet sein. Er wirkt auch ohne Wandanschluss druckmindernd und kann alternativ oder zusätzlich zu den vorstehend beschriebenen Auskleidungen des Gehäuses mit offenporigem Material Anwendung finden.

Beispiele ergeben sich aus Ansprüche, Zeichnungen und der Beschreibung. Die Erfindung wird durch die beigefügten Ansprüche definiert. Die Zeichnungen zeigen:
Figur 1 ein erfindungsgemäßes Gehäuse mit verschiedenen Maßnahmen zur Druckreduktion, in schematisierter Darstellung;
Figur 2 einen Ausschnitt aus einem druckreduzierenden offenporigen Körper des Gehäuses nach Figur 1;
Figur 3 und 4 weitere Ausführungsformen des erfindungsgemäßen Gehäuses jeweils, in schematisierter Querschnittsdarstellung.

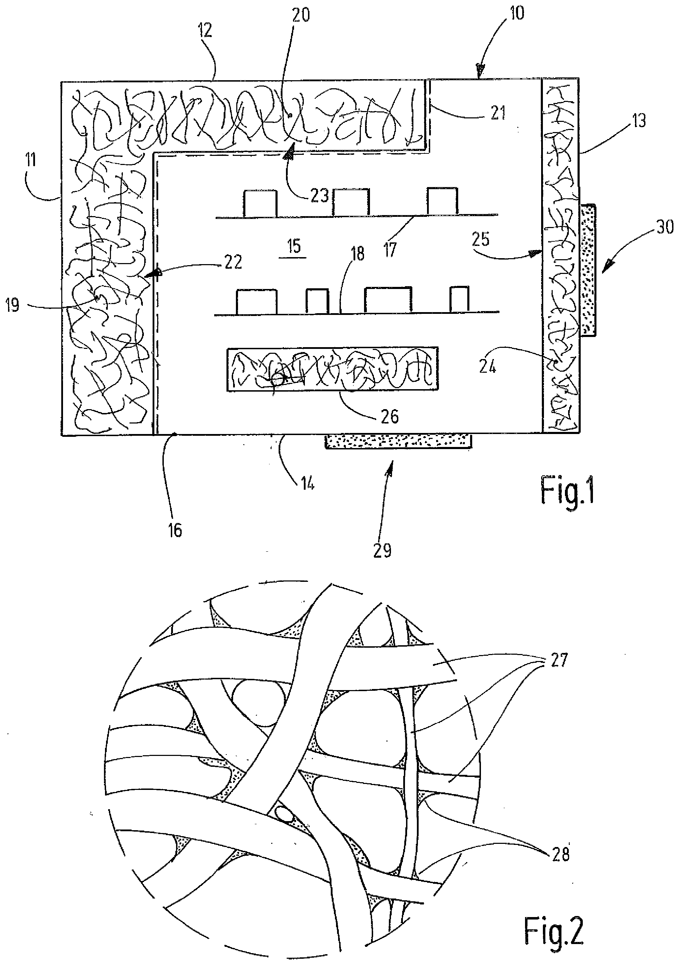

In Figur 1 ist ein explosionsgeschütztes Gehäuse 10 veranschaulicht, das mehrere Wänden 11, 12, 13, 14 umfasst, die einen nach außen abgeschlossenen Innenraum 15 umgrenzen. Die Wände 11 bis 14 bilden zusammen mit einem nicht weiter veranschaulichten Boden und einem Deckel eine Wandanordnung 16. Boden und Deckel diese Gehäuses können mit den Wänden 11 bis 14 fest oder auch lösbar verbunden sein. Sie werden weiterhin ebenfalls als Wände angesehen.

In dem Innenraum 15 können Bauelemente und Komponenten wie beispielsweise Leiterplatten, 17, 18 mit darauf angeordneten elektrischen Bauelementen angeordnet sein, die Zündquellen bilden können.

An wenigstens zwei Wänden 11, 12 des Gehäuses 10 ist offenporiges Material 19, 20 zum Beispiel in Gestalt von Platten, Körpern oder Matten angeordnet, das die jeweilige Wand 11, 12 jeweils ganz oder teilweise bedeckt. Das offenporige Material ist dabei vorzugsweise unmittelbar an die jeweilige Wand 11, 12 anliegend angeordnet und weiter vorzugsweise mit dieser verbunden. Die Verbindung kann durch vollflächiges Verkleben, Verschweißen oder durch andere Verbindungsmaßnahmen, erfolgen, die zu einer stoffschlüssigen teil- oder vollflächigen Verbindung führen. Alternativ oder zusätzlich kann das offenporige Material 19, 20 in einer Aufnahme gehalten sein, die beispielsweise durch eine Gitterstruktur 21 gebildet ist. Die Gitterstruktur 21 kann ein Lochblechgehäuse, ein Drahtgitter, ein Käfig oder dergleichen sein, der mit dem Gehäuse 10 verbunden ist und das offenporige Material 19, 20 von dem sonstigen Innenraum 15 fernhält.

Das offenporige Material 19, 20 weist an seiner jeweils zu dem Innenraum 15 hin weisenden Seite Flächen 22, 23 auf, die wie dargestellt in einem Winkel zueinander angeordnet sind, der kleiner als 180° ist.

Alternativ oder zusätzlich zu dem offenporigen Material 20 ist den offenporigem Material 19 gegenüberliegend ein weiterer Abschnitt 24 offenporigen Materials angeordnet. Dieses kann das gleiche oder ein anderes offenporiges Material wie die Materialien 19, 20 sein. Es kann die gleiche oder eine unterschiedliche Dicke aufweisen. Ebenso können die offenporigen Materialien 19, 20 gleiche oder unterschiedliche Dicken aufweisen. Das Material 24 weist eine dem Innenraum 15 zugewandte Fläche 25 auf, die der Fläche 22 gegenüberliegt und die zu der Fläche 23 im Winkel von z.B. 90° angeordnet ist.

Das offenporige Material 19, 20 und/oder 24 bildet eine innere
Druckentlastungsvorrichtung. Eine weitere innere Druckentlastungsvorrichtung kann durch einen offenporigen Körper 26 gebildet sein, der an wenigstens vier, vorzugsweise an fünf oder sechs Seiten frei, d.h. nicht an einer der Wände der Wandanordnung anliegend, in dem Innenraum 15 des Gehäuses 10 angeordnet ist. Der offenporige Körper 26 ist vorzugsweise ein Faserkörper, dessen Fasern durch ein Bindemittel untereinander verbunden sind. Figur 2 veranschaulicht schematisiert einen Ausschnitt aus dem Körper 26. Wie ersichtlich sind mehrere Fasern 27 in räumlich ungeordneter Anordnung miteinander verschlungen und an wenigstens einigen ihrer Kreuzungsstellen durch Bindemittel 28 verbunden. Bei den Fasern kann es sich um Metallfasern oder mineralische Fasern insbesondere Glasfasern, Quarzfasern, Steinfasern, Keramikfasern, handeln. Das Bindemittel 28 kann ein Kunstharz, insbesondere ein Phenolharz, sein. Der Harzanteil ist so gering, dass die zwischen den Fasern 27 vorhandenen Poren offen bleiben. Er ist jedoch so groß, dass der offenporige Körper 26 eine erhebliche Formstabilität hat, so dass er bei Zündung einer Explosion in dem Innenraum 15 nicht aufgelöst wird und möglichst keine oder allenfalls ein unschädliches Quantum Fasern freisetzt.

Bei den Fasern 27 kann es sich um die gleichen Fasen handeln, die auch für das offenporige Material 19, 20, 24 Anwendung findet. Dieses kann ebenfalls vorverdichtet und, falls gewünscht, auch mit Bindemittel versehen sein.

Das Gehäuse 10 ist mit wenigstens einer Druckentlastungsvorrichtung 30 und einer eventuellen zusätzlichen Druckentlastungsvorrichtung 29 versehen. Beide Druckentlastungsvorrichtungen 29, 30 sind poröse gasdurchlässige Körper mit einer Spaltweite und Spaltlänge, die einen Flammendurchschlag verhindert. Die Druckentlastungsvorrichtung 29 ist in einem von porösem Material freien Abschnitt der Wand 14 des Gehäuses 10 angeordnet. Die Druckentlastungsvorrichtung 30 ist von dem Innenraum 15 her gesehen durch das offenporige Material 25 bedeckt. Dieses hindert den Gasdurchtritt jedoch nicht.

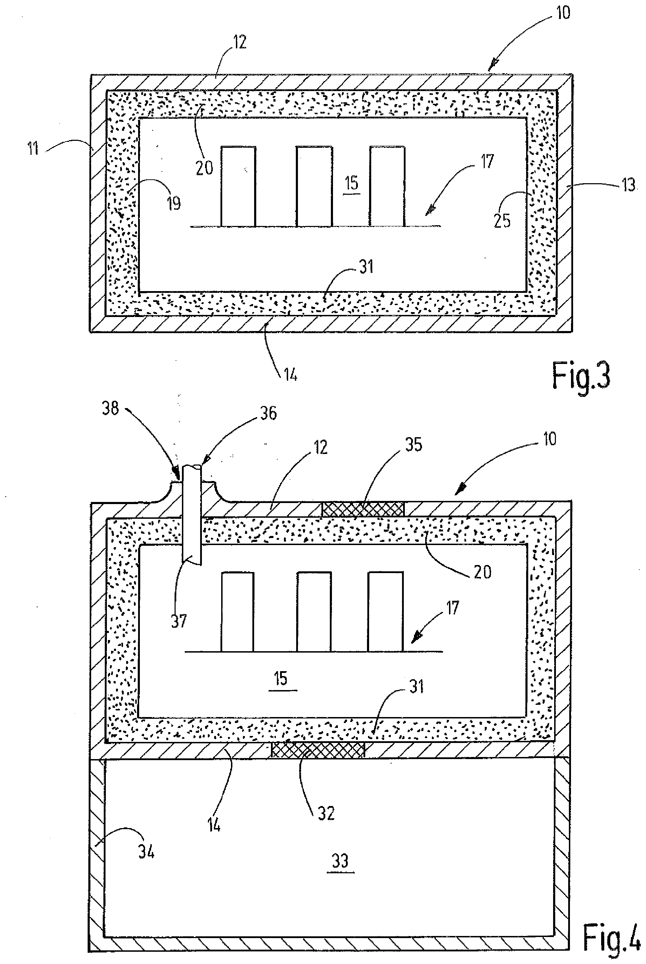

Figur 3 veranschaulicht eine abgewandelte Ausführungsform des erfindungsgemäßen Gehäuses 10. Die vorige Beschreibung gilt unter Verwendung der bereits eingeführten Bezugszeichen entsprechend. Im Unterschied zu dem zuvor beschriebenen Gehäuses 10 weist das Gehäuse 10 nach Figur 3 poröses Material 19, 20, 25, 31 an allen vier Wänden 11, 12, 13, 14 des Gehäuses und optional zusätzlich an dem nicht veranschaulichten Boden und/oder dem Deckel auf. Das offenporige Material 19, 20, 25, 31 bildet eine an den Wänden entlang führende lokal unterbrochener oder auch ununterbrochene Schicht, die eine in dem Innenraum 15 gezündete Flammenfront auffängt und die entstehende Druckwelle absorbiert.

Bei dem in Figur 4 veranschaulichten Gehäuse 10 handelt es sich um eine auf dem Gehäuse 10 nach Figur 3 aufbauende Ausführungsform. Dieses Gehäuse weist eine Druckentlastungsvorrichtung 32 auf, die flammendurchschlagsicher ausgebildet und in der Wand 14 angeordnet ist, an die sich ein Expansionsvolumen 33 anschließt. Dieses kann durch ein Teilgehäuse 34 von der Umgebung getrennt und gegen diese abgeschlossen sein oder auch Öffnungen aufweisen, über die es mit der Umgebung in Verbindung steht.

Zusätzlich oder alternativ kann in der Wand 12 ein Druckentlastungskörper 35 vorgesehen sein, der eine Druckentlastung zur Umgebung hin ermöglicht. Der flammendurchschlagsichere Druckentlastungskörper 35 kann innen wiederum von dem porösen Material 20 überdeckt sein oder freiliegen. Außerdem kann eine Durchführungseinrichtung 36 vorgesehen sein, indem beispielsweise eine Welle 37 durch die Gehäusewand 12 geführt ist. Dazu kann die Welle 37 mit der Gehäusewand 12 einen zünddurchschlagsicheren Spalt 38 festlegen. Die Welle 37 kann durch das offenporige Material 20 geführt sein und Bewegungen zwischen Elementen außerhalb des Gehäuses 10 zu Elementen innerhalb des Gehäuses 10 übertragen.

Das erfindungsgemäße Gehäuse 10 kann zur Reduktion von internem Explosionsdruck innen mit einer vorzugsweise wenigstens zwei Seiten des Gehäuses 10 umfassenden Auskleidung aus offenporigen Material versehen sein. Zusätzlich oder alternativ kann in dem Gehäuse ein Formkörper aus offenporigem Material insbesondere gebundenem Fasermaterial angeordnet sein.

### Bezugszeichen:

| | |
|---|---|
| 10 | Gehäuse |
| 11 - 14 | Wände |
| 15 | Innenraum |
| 16 | Wandanordnung |
| 17, 18 | Leiterplatten |
| 19, 20 | offenporiges Material |
| 21 | Gitterstruktur |
| 22, 23 | Flächen des offenporigen Materials |
| 24 | Abschnitt des offenporigen Materials |
| 25 | Fläche |
| 26 | offenporiger Körper |
| 27 | Fasern |
| 28 | Bindemittel |
| 29, 30 | Druckentlastungsvorrichtung |
| 31 | offenporiges Material |
| 32 | Druckentlastungskörper |
| 33 | Expansionsvolumen |
| 34 | Teilgehäuse |
| 35 | Druckentlastungskörper |
| | |

## Patentansprüche

1. Gehäuse (10) der Schutzart ex-d,
mit einer Wandanordnung (16), die mehrere Wände (11, 12, 13, 14) aufweist,
die einen Innenraum (15) umschließen,
wobei wenigstens zwei der Wände (11, 12) der Wandanordnung (16) mit einem offenporigen Material (19, 20) ohne Sicherheit gegen Flammendurchschlag versehen sind, und dadurch ein das offenporige Material (19, 20) tragender Bereich der wenigstens zwei der Wände (16) definiert ist,
**dadurch gekennzeichnet, dass** das Gehäuse (10) mit wenigstens einer durch einen porösen, gasdurchlässigen Körper gebildeten Druckentlastungseinrichtung (29 und/oder 30) versehen ist, die eine Strömungsverbindung zwischen dem Innenraum (15) und der Umgebung ermöglicht, dass die wenigstens eine Druckentlastungseinrichtung (29 und/oder 30)
ein gasdurchlässiger Körper (29 und/oder 30) mit einer Spaltweite und Spaltlänge ist, die einen Flammendurchschlag verhindert, und
dass der das offenporige Material (19, 20) tragende Bereich der wenigstens zwei der Wände (11, 21) wenigstens eine Öffnung aufweist, die mit dem gasdurchlässigen, flammendurchschlagsicheren Körper (30) versehen ist.

2. Gehäuse nach Anspruch 1, wobei das offenporige Material (10, 20) unmittelbar an den beiden der wenigstens zwei der Wänden (11, 12) anliegend angeordnet ist.

3. Gehäuse nach einem der vorstehenden Ansprüche, wobei das Material (19, 20) an jeder der wenigstens zwei der Wände (11, 12), an denen es angebracht ist, eine wandabgewandte Fläche (22, 23) aufweist, die dem Innenraum (15) zugewandt ist.

4. Gehäuse nach Anspruch 3, wobei die wandabgewandte Fläche (22, 23) parallel zu der jeweiligen Wand der wenigstens zwei der Wände (11, 12) oder im spitzen Winkel zu dieser verlaufend angeordnet ist.

5. Gehäuse nach einem der vorstehenden Ansprüche, wobei das offenporige Material (19, 20; ein Fasermaterial ist.

6. Gehäuse nach einem der vorstehenden Ansprüche, wobei das offenporige Material (19, 20) von einer Gitterstruktur (21) eingefasst ist, die mit der Wandanordnung (16) verbunden ist.

7. Gehäuse nach einem der vorstehenden Ansprüche, wobei der das offenporige Material (19, 20) tragende Bereich der wenigstens zwei der Wände (11, 21) geschlossen ausgebildet ist oder lediglich flammendurchschlagsichere Spalte (38) aufweist.

8. Gehäuse nach Anspruch 1, wobei in dem Innenraum ein offenporiger Körper (26) angeordnet ist und dass der offenporige Körper (26) aus einer durch ein Bindemittel (28) formhaltig gebunden, metallischen oder mineralischen Faseranordnung besteht.

9. Gehäuse nach Anspruch 8, wobei die Faseranordnung (26) Metallfasern, Glasfasern, Quarzfasern, Gesteinsfasern, Keramikfasern oder ein Gemisch aus diesen aufweist und dass das Bindemittel ein Kunstharz ist.

10. Gehäuse nach Anspruch 8, wobei das Bindemittel (28) ein Kunstharz ist.

11. Gehäuse nach Anspruch 8, wobei das Bindemittel (28) ein organischer Binder ist.

## Claims

1. Housing (10) of protection class ex-d,
with a wall arrangement (16) comprising several walls (11, 12, 13, 14) surrounding an interior (15),
wherein at least two of the walls (11, 12) of the wall arrangement (16) are provided with an open-pore material (19, 20) with no security against flame breakthrough, and thereby a region of the at least two walls (16) carrying the open-pore material (19, 20) is defined,
**characterized in that** the housing (10) is provided with at least one pressure-relief device (29 and/or 30) which is formed by a porous gas-permeable body and allows a fluidic connection between the interior (15) and the environment,
that the at least one pressure-relief valve (29 and/or 30) is a gas-permeable body (29 and/or 30) with a gap width and gap length which prevent a flame breakthrough, and that the region of the at least two walls (11, 21) carrying the open-pore material (19, 20) has at least one opening which is provided with the gas-permeable body (30) which is secure against flame breakthrough.

2. Housing according to claim 1, wherein the open-pore material (10, 20) is arranged lying directly on both of the at least two walls (11, 12).

3. Housing according to any of the preceding claims, wherein on each of the at least two walls (11, 12) on which it is attached, the material (19, 20) has a surface (22, 23) facing away from the wall and towards the interior (15).

4. Housing according to claim 3, wherein the surface (22, 23) facing away from the wall is arranged parallel to the respective wall of the at least two walls (11, 12) or at an acute angle thereto.

5. Housing according to any of the preceding claims, wherein the open-pore material (19, 20) is a fibre material.

6. Housing according to any of the preceding claims, wherein the open-pore material (19, 20) is encased by a lattice structure (21) which is connected to the wall arrangement (16).

7. Housing according to any of the preceding claims, wherein the region of the at least two walls (11, 21) carrying the open-pore material (19, 20) is formed closed or has only gaps (38) which are secure against flame breakthrough.

8. Housing according to claim 1, wherein an open-pore body (26) is arranged in the interior and the open-pore body (26) consists of a metallic or mineral fibre arrangement bonded form-stably by a binding agent (28).

9. Housing according to claim 8, wherein the fibre arrangement (26) comprises metal fibres, glass fibres, quartz fibres, rock fibres, ceramic fibres or a mixture thereof, and the binding agent is a synthetic resin.

10. Housing according to claim 8, wherein the binding agent (28) is a synthetic resin.

11. Housing according to claim 8, wherein the binding agent (28) is an organic binding agent.

## Revendications

1. Boîtier (10) doté de la protection de type ex-d, comprenant un agencement de parois (16) qui présente plusieurs parois (11, 12, 13, 14) entourant un espace interne (15), au moins deux des parois (11, 12) de l'agencement de parois (16) étant munies d'un matériau à pores ouverts (19, 20) dépourvu de protection contre le passage de flammes, et une zone des au moins deux des parois (16) qui porte le matériau à pores ouverts (19, 20) étant ainsi définie,
**caractérisé en ce que** le boîtier (10) est doté d'au moins un dispositif de décompression (29 et/ou 30) qui est constitué d'un corps poreux perméable aux gaz et permet d'établir une communication d'écoulement entre l'espace interne (15) et le milieu ambiant, **en ce que** le dispositif de décompression (29 et/ou 30), au nombre d'au moins un, est un corps (29 et/ou 30) perméable aux gaz, doté d'une largeur d'interstice et d'une longueur d'interstice qui empêche un passage de flammes, et **en ce que** la zone des au moins deux des parois (11, 21) qui porte le matériau à pores ouverts (19, 20) présente au moins une ouverture qui est pourvue du corps (30) perméable aux gaz, empêchant le passage de flammes.

2. Boîtier selon la revendication 1, dans lequel le matériau à pores ouverts (10, 20) est disposé de manière à être appliqué directement contre les au moins deux des parois (11, 12).

3. Boîtier selon l'une des revendications précédentes, dans lequel le matériau (19, 20) présente, sur chacune des au moins deux parois des (11, 12) sur lesquelles il est appliqué, une surface (22, 23) qui est opposée à la paroi et tournée vers l'espace interne (15).

4. Boîtier selon la revendication 3, dans lequel la surface (22, 23) opposée à la paroi est disposée parallèlement à la paroi respective des au moins deux des parois (11, 12) ou en formant un angle aigu par rapport à celle-ci.

5. Boîtier selon l'une des revendications précédentes, dans lequel le matériau à pores ouverts (19, 20) est un matériau en fibres.

6. Boîtier selon l'une des revendications précédentes, dans lequel le matériau à pores ouverts (19, 20) est entouré d'une structure de grille (21) qui est reliée à l'agencement de parois (16).

7. Boîtier selon l'une des revendications précédentes, dans lequel la zone des au moins deux des parois (11, 21) qui porte le matériau à pores ouverts (19, 20) est réalisée sous une forme fermée ou présente seulement des interstices empêchant le passage de flammes (38).

8. Boîtier selon la revendication 1, dans lequel un corps à pores ouverts (26) est disposé dans l'espace interne, et en ce que le corps à pores ouverts (26) est constitué d'un système de fibres métalliques ou minérales qui est lié par un liant (28) de manière à conserver sa forme.

9. Boîtier selon la revendication 8, dans lequel le système de fibres (26) présente des fibres métalliques, des fibres de verre, des fibres de quartz, des fibres de roche ou un mélange de celles-ci, et en ce que le liant est une résine synthétique.

10. Boîtier selon la revendication 8, dans lequel le liant (28) est une résine synthétique.

11. Boîtier selon la revendication 8, dans lequel le liant (28) est un liant organique.
